Europäisches Patentamt

European Patent Office

Office européen des brevets

(19)

(11)  EP 0 763 892 B1

(12)  **FASCICULE DE BREVET EUROPEEN**

(45) Date de publication et mention
de la délivrance du brevet:
**09.05.2001  Bulletin 2001/19**

(51) Int Cl.⁷: **H03H 17/02**

(21) Numéro de dépôt: **96401922.8**

(22) Date de dépôt: **09.09.1996**

(54) **Banc de filtres en treillis à reconstruction parfaite**

Gitterfilterbank mit perfekter Rekonstruktion

Perfect reconstruction lattice filter bank

(84) Etats contractants désignés:
**DE GB**

(30) Priorité: **14.09.1995  FR 9510889**

(43) Date de publication de la demande:
**19.03.1997  Bulletin 1997/12**

(73) Titulaires:
• **FRANCE TELECOM**
**75015 Paris (FR)**
• **Etablissement Public Télédiffusion de France**
**75015 Paris (FR)**

(72) Inventeurs:
• **Siohan, Pierre**
**35200 Rennes (FR)**
• **Pinchon, Didier**
**31750 Escalquens (FR)**

(74) Mandataire: **Cabinet Martinet & Lapoux**
**BP 405**
**78055 Saint Quentin en Yvelines Cédex (FR)**

(56) Documents cités:
**FR-A- 2 667 745**

**Description**

La présente invention a trait à un banc de filtres pour filtrer un signal numérique en deux sous-bandes de fréquence. Le banc de filtres comprend un bloc d'analyse et un bloc de synthèse. Plus particulièrement, le bloc d'analyse comprend deux filtres à réponse impulsionnelle finie, à phase linéaire, symétrique. Les fonctions de transfert des deux filtres sont des polynômes de longueurs impaires qui diffèrent d'un multiple impair de 2. Le bloc de synthèse comprend deux filtres de même type qui se déduisent des filtres d'analyse par la propriété de reconstruction parfaite.

Des filtres à réponse impulsionnelle finie connus ont une structure transverse. La structure transverse est complexe à mettre en oeuvre. Une structure en treillis a été proposée pour simplifier la réalisation des filtres (FR-A-2 667 745). Cependant, le nombre de paramètres à déterminer pour les réaliser est important, ce qui entraîne une grande complexité opératoire exprimée en nombre d'additions et multiplications par unité de temps. En outre, la structure en treillis connue n'est pas canonique, c'est-à-dire elle n'emploie pas le nombre minimal d'éléments tels que retard par exemple.

La présente invention vise à remédier aux inconvénients de la technique antérieure en fournissant une structure de filtres à deux sous-bandes qui présente une complexité opératoire minimale.

A cette fin, un dispositif pour analyser un signal numérique en deux sous-bandes de fréquence est caractérisé en ce qu'il comprend au moins une cellule comprenant :

- depuis une première entrée de la cellule, une ligne à retard reliée à un multiplieur relié à une première entrée d'un additionneur ayant une sortie formant une première sortie de la cellule,
- une liaison directe entre une seconde entrée et une seconde sortie de la cellule, et
- un filtre entre la seconde entrée de la cellule et une seconde entrée de l'additionneur.

En pratique le dispositif comprend une suite de plusieurs cellules successives. La sortie de l'additionneur de l'une de deux cellules successives est reliée à la liaison directe de l'autre desdits deux cellules successives, et la liaison directe de ladite l'une des deux cellules successives a une sortie reliée à une entrée de la ligne à retard de ladite autre des deux cellules successives.

Le dispositif pour filtrer peut comprendre en outre une cellule d'extrémité comprenant :

- entre une première entrée et une première sortie de la cellule d'extrémité, un filtre relié à une première entrée d'un additionneur ayant une sortie formant la première sortie de la cellule d'extrémité,
- une liaison directe entre ladite première entrée et une seconde sortie de la cellule d'extrémité, et
- une ligne à retard et un multiplieur reliés en série entre une seconde entrée de la cellule d'extrémité et une seconde entrée de l'additionneur.

De préférence, la sortie de l'additionneur de la cellule d'extrémité est reliée à la liaison directe d'une première cellule dans ladite suite de cellules, et la seconde sortie de ladite cellule d'extrémité est reliée à la ligne à retard de ladite première cellule dans ladite suite.

Dans un autre aspect de l'invention, un dispositif pour synthétiser un signal numérique, est caractérisé en ce qu'il comprend au moins une cellule comprenant :

- une combinaison série d'une ligne à retard et d'un multiplieur entre une première entrée et une première sortie de la cellule,
- depuis ladite première entrée, un filtre relié à une première entrée d'un additionneur ayant une sortie formant une seconde sortie de la cellule, et
- une liaison directe entre une seconde entrée de la cellule et une seconde entrée du additionneur.

Le dispositif pour synthétiser comprend en pratique une suite de plusieurs cellules successives. La sortie de l'additionneur de l'une de deux cellules successives est reliée à la combinaison série de l'autre desdites deux cellules successives, et la combinaison série de ladite une des deux cellules successives a une sortie reliée à la seconde entrée de l'additionneur de ladite autre des deux cellules sucessives.

Le dispositif pour synthétiser peut comprendre en outre une cellule d'extrémité comprenant :

- entre une première entrée et une première sortie de la cellule d'extrémité, un filtre relié à une première entrée d'un additionneur ayant une sortie formant ladite première sortie de la cellule d'extrémité,
- une liaison directe entre une seconde entrée de la cellule d'extrémité et une seconde entrée de l'additionneur, et
- un multiplieur entre la première entrée de la cellule d'extrémité et une seconde sortie de la cellule d'extrémité.

L'entrée du filtre de la cellule d'extrémité dans le dispositif pour synthétiser est reliée à la sortie de l'additionneur d'une dernière cellule dans ladite suite de cellules, et la seconde entrée de l'additionneur de la cellule d'extrémité est reliée à la sortie de la combinaison série de ladite dernière cellule dans ladite suite.

D'autres caractéristiques et avantages de la présente invention apparaîtront plus clairement à la lecture de la description suivante de plusieurs réalisations préférées de l'invention en référence aux dessins annexés correspondants dans lesquels :

- la figure 1 est un bloc-diagramme schématique d'un banc de filtres numériques à deux sous-bandes de fréquence selon la technique antérieure ;
- la figure 2 est un bloc d'analyse selon l'invention inclus dans le banc de filtres de la figure 1 ;
- la figure 3 est un algorithme d'identification du bloc d'analyse de la figure 2 ;
- les figures 4, 5 et 6 sont des algorithmes détaillés de l'identification du bloc d'analyse de la figure 2 ;
- la figure 7 est un exemple de réalisation d'un bloc d'analyse selon l'invention ;
- la figure 8 est un bloc de synthèse selon l'invention inclus dans le banc de filtres de la figure 1 ; et
- la figure 9 est un exemple de réalisation d'un bloc de synthèse selon l'invention, correspondant au bloc d'analyse de la figure 7.

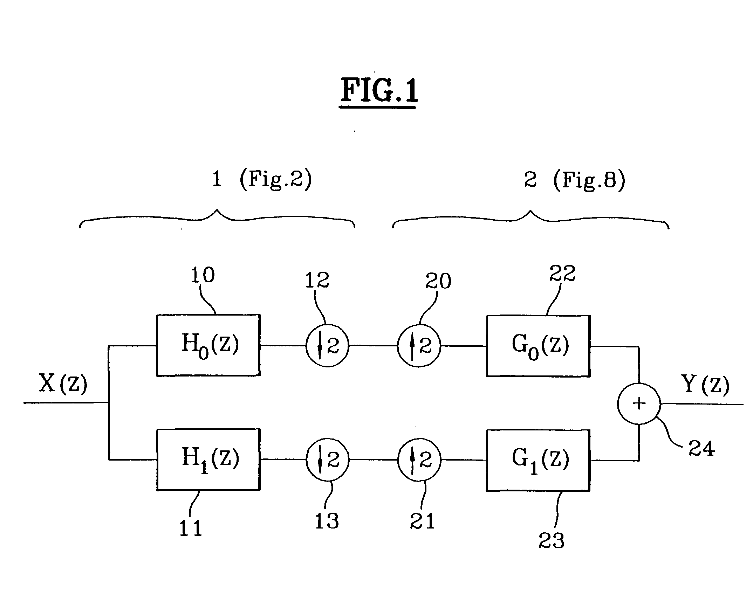

En référence à la **figure 1**, un banc de filtres numériques à deux sous-bandes de fréquence pour filtrer un signal numérique de transformée en z égale à X(z), z désignant une variable complexe, comprend un premier bloc, dit bloc d'analyse 1, et un second bloc, dit bloc de synthèse 2.

Le bloc d'analyse 1 comprend deux filtres numériques d'analyse parallèles 10 et 11 qui reçoivent à une entrée commune le signal numérique X(z) à analyser en deux sous-bandes de fréquence. Le filtre 10 est un filtre passe-bas et le filtre 11 est un filtre passe-haut. Des sorties des filtres d'analyse 10 et 11 sont reliés respectivement à des décimateurs d'ordre 2, 12 et 13.

Le bloc de synthèse 2 comprend deux interpolateurs d'ordre 2 parallèles 20 et 21. Chacun des interpolateurs 20 et 21 est relié en sortie à un filtre numérique de synthèse 22 et 23. Des sorties des filtres 22 et 23 sont reliées à des entrées d'un sommateur 24. Le sommateur 24 délivre en sortie un signal Y(z).

Les blocs d'analyse et de synthèse 1 et 2 sont reliés de sorte qu'une sortie du décimateur 12, 13, soit reliée à une entrée de l'interpolateur 20, 21.

Les filtres d'analyse et de synthèse sont de type à réponse impulsionnelle finie (RIF) à phase linéaire.

Les fonctions de transfert des filtres d'analyse 10 et 11 sont des polynômes $H_0(z)$ et $H_1(z)$, et les fonctions de transfert des filtres de synthèse 22 et 23 sont des polynômes $G_0(z)$ et $G_1(z)$.

Pour éliminer tout repliement de spectre, les fonctions de transfert des filtres d'analyse et de synthèse vérifient les relations suivantes :

$$G_0(z) = 2.H_1(-z) \text{ et}$$

$$G_1(z) = 2.H_0(-z) .$$

Le banc de filtres est à reconstruction parfaite : le signal de sortie Y(z) est égal au signal d'entrée X(z) à un retard près. Les signaux d'entrée et de sortie vérifient donc : $Y(z) = z^{-D}.X(z)$, où D est un retard exprimé en nombre d'échantillons de signal qui dépend de la longueur des filtres.

Les filtres 10 et 11 sont symétriques et leurs fonctions de transfert respectives sont des polynômes de longueurs impaires respectives 2p + 1 et 2q + 1, avec p et q entiers.

Les fonctions de transfert $H_0(z)$ et $H_1(z)$ s'écrivent sous la forme :

$$H_0(z) = \sum_{m=0}^{2p} h_0(m).z^{-m}$$

$$= a(z^2) + z^{-1} . b(z^2)$$

et

$$H_1(z) = \sum_{m=0}^{2q} h_1(m) . z^{-m}$$

$$= c(z^2) + z^{-1} . d(z^2)$$

où a(z) et b(z), c(z) et d(z) sont des composantes polyphase symétriques de degré p et p-1, q et q-1, respectivement des fonctions de transfert $H_0(z)$ et $H_1(z)$.

La matrice des composantes polyphases des fonctions de transfert $H_0(z)$ et $H_1(z)$ est :

$$MCP(z) = \begin{pmatrix} a(z) & b(z) \\ c(z) & d(z) \end{pmatrix}$$

La matrice des composantes polyphases détermine alors complètement le bloc de filtre d'analyse 1 :

$$M(z) = \begin{bmatrix} H_0(z) \\ H_1(z) \end{bmatrix} = MCP(z^2).\begin{pmatrix} 1 \\ z^{-1} \end{pmatrix}$$

Une condition nécessaire et suffisante pour que le banc de filtre de la figure 1 soit à reconstruction parfaite est que :

$$\det MCP\ (z) = \beta.z^{-k}$$

où det MCP(z) dénote le déterminant de la matrice MCP(z), $\beta$ un nombre non nul et k un entier.

Soit les polynômes $\bar{a}(z)$, $\bar{b}(z)$, $\bar{c}(z)$ et $\bar{d}(z)$ vérifiant :

$$a\ (z) = z^{-p/2} . \bar{a}\ (z^{1/2} + z^{-1/2})\ ,$$

$$b\ (z) = z^{-(p-1)/2} . \bar{b}\ (z^{1/2} + z^{-1/2})\ ,$$

$$c(z) = z^{-q/2} \cdot \bar{c}\,(z^{1/2} + z^{-1/2}) \;,$$

et

$$d(z) = z^{-(q-1)/2} \cdot \bar{d}\,(z^{1/2} + z^{-1/2}) \;.$$

La condition de reconstruction parfaite s'écrit alors :

$$a(z) \cdot d(z) - b(z) \cdot c(z) = \beta \cdot z^{-k} \;,$$

d'où :

$$\bar{a}\,(u) \cdot \bar{d}\,(u) - \bar{b}\,(u) \cdot \bar{c}\,(u) = \beta$$

avec $2k = p + q - 1$ et $u$ une variable réelle égale à $z^{1/2} + z^{-1/2}$.

Si $\beta = 1$ et si $\bar{a}\,(u)$ et $\bar{b}\,(u)$ sont premiers entre eux, d'après le théorème de Bezout, il existe un couple unique de polynômes $(\bar{c}_0, \bar{d}_0)$ vérifiant :

$$\bar{a}(u) \cdot \bar{d}_0(u) - \bar{b}(u) \cdot \bar{c}_0(u) = 1$$

avec

$$\deg(\bar{c}_0(u)) < \deg(\bar{a}(u))$$

et

$$\deg(\bar{d}_0\,(u)) < \deg(\bar{b}(u))$$

où deg dénote le degré du polynôme.

Il existe un filtre symétrique de fonction de transfert $H_1^0(z)$ de longueur impaire strictement inférieure à celle de $H_0(z)$ et égale à $2p-4m-1$, avec $m$ un entier positif ou nul, tel que le système $(H_0, H_1^0)$ soit à reconstruction parfaite. Le filtre $H_1^0(z)$ est unique à une constante multiplicative près.

$$H_1^0(z) = z^{-\deg(\bar{c}_0)} \cdot \bar{c}_0(z + z^{-1}) +$$
$$z^{-(\deg(\bar{d}_0)+1)} \cdot \bar{d}_0\,(z + z^{-1})$$

La solution générale est :

$$H_1(z) = \alpha \cdot z^{-2(r+m+1)} \cdot H_1^0(z) + Q(z^2) \cdot H_0(z)$$

dans laquelle $Q(z)$ est un polynôme non nul, symétrique de degré impair égal à $2r + 1$, $r$ étant un entier, et $\alpha$ est une constante non nulle.

Le polynôme $H_1(z)$ est unitaire si et seulement si le polynôme $Q(z)$ est unitaire.

Si $MCP^0(z)$ est la matrice des composantes polyphases du système $(H_0, H_1^0)$, la matrice des composantes polyphases des fonctions de transfert $H_0(z)$ et $H_1(z)$ est :

$$MCP(z) = \begin{pmatrix} 1 & O \\ Q(z) & \alpha z^{-(r+m+1)} \end{pmatrix} MCP^0(z)$$

en réitérant la décomposition de la matrice $MCP^0(z)$, la matrice des composantes polyphases de bloc d'analyse ($H_0$, $H_1$) est :

$$MCP(z) = [\prod_{i=1}^{N-1} M(i, Q_i, \alpha_i, k_i + k_{i+1} + 1)] \cdot M_0(N, Q_N, \alpha_N)$$

avec

: N un entier positif,
: $\alpha_i$ une suite de nombres réels non nuls, pour $1 \le i \le N$ ,
: $k_i$ une suite d'entiers, pour $1 \le i \le N$ ,
: $Q_i$ une suite de polynômes unitaires symétriques de degré impair, pour $1 \le i \le N$: $\deg(Q_i) = 2k_i + 1$ , et

$$M(i, Q_i, \alpha_i, k_i + k_{i+1} + 1)$$

$$\begin{pmatrix} 1 & 0 \\ Q_i(z) & \alpha_i \cdot z^{-(k_i + k_{i+1} + 1)} \end{pmatrix}$$

lorsque i est pair, et

$$M(i, Q_i, \alpha_i, k_i + k_{i+1} + 1)$$

$$= \begin{pmatrix} \alpha_i \cdot z^{-(k_i + k_{i+1} + 1)} & Q_i(z) \\ 0 & 1 \end{pmatrix}$$

lorsque i est impair,
avec

$$M_0(N, Q_N, \alpha_N) = \begin{pmatrix} 1 & 0 \\ Q_N(z) & \alpha_N \cdot z^{-k_N} \end{pmatrix}$$

lorsque N est pair, et

$$M_O(N, \ Q_N, \ \alpha_N) \ = \ \begin{pmatrix} Q_N(z) & \alpha_N \cdot z^{-k_N} \\ 1 & 0 \end{pmatrix}$$

lorsque N est impair.

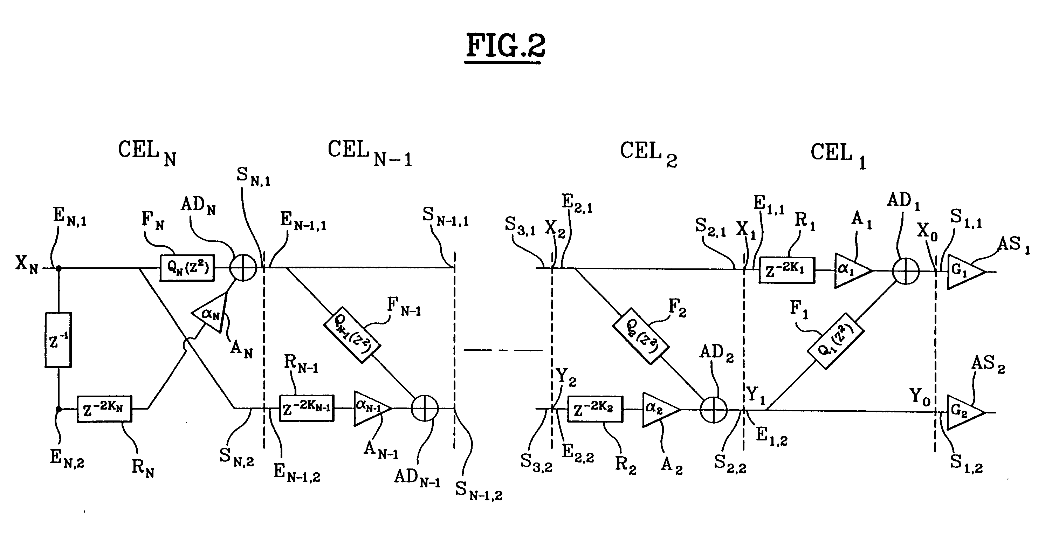

En référence à la **figure 2**, le bloc d'analyse 1 est formé de N quadripôles ou cellules à deux entrées et deux sorties successives $CEL_N$ à $CEL_1$. Les cellules $CEL_1$ à $CEL_{N-1}$ ont alternativement une structure de rang impair et une structure de rang pair qui sont quelque peu différentes.

La cellule $CEL_1$ de rang impair correspond à la matrice $M(1, Q_1, \alpha_1, k_1+k_2+1)$.

A partir d'une première entrée $E_{1,1}$, la cellule $CEL_1$ comprend une ligne à retard $R_1$ de fonction de transfert $z^{-2K_1}$, avec $K_1 = k_1 + k_2 + 1$. La ligne à retard $R_1$ est reliée à un amplificateur ou multiplieur $A_1$ de gain $\alpha_1$. Le multiplieur $A_1$ est relié à une première entrée d'un additionneur $AD_1$. Une sortie de l'additionneur $AD_1$ forme une première sortie $S_{1,1}$ de la cellule $CEL_1$. A partir d'une seconde entrée $E_{1,2}$, la cellule $CEL_1$ comprend un filtre $F_1$ de fonction de transfert $Q_1(z^2)$ dont une sortie est reliée à une seconde entrée de l'additionneur $AD_1$. Il est à noter que la fonction de transfert $Q_1(z^2)$ exprimée en fonction de la variable $z^2$ correspond au cas où la décimation est effectuée après le filtrage. Il y a équivalence avec le cas où la décimation est effectuée préalablement au filtrage, les fonctions de transfert des filtres étant alors exprimées en fonction de la variable z. La seconde entrée $E_{1,2}$ de la cellule $CEL_1$ est reliée directement à une seconde sortie $S_{1,2}$ de la cellule $CEL_1$.

Un premier signal d'entrée $X_1$ appliqué à la première entrée $E_{1,1}$ de la cellule $CEL_1$ est multiplié par $\alpha_1.z^{-2K_1}$, avec $K_1 = k_1 + k_2 + 1$. Un second signal d'entrée $Y_1$ appliqué à la seconde entrée $E_{1,2}$ de la cellule $CEL_1$ est filtré par $Q_1(z^2)$ puis additionné au signal $X_1.\alpha_1.z^{-2K_1}$ pour former un premier signal de sortie $X_0$. Un second signal de sortie $Y_0$ est égal au second signal d'entrée $Y_1$.

La cellule $CEL_1$ transforme les signaux d'entrée $X_1$ et $Y_1$ en les signaux de sortie $X_0$ et $Y_0$ :

$$X_0 = X_1. \ \alpha_1.z^{-2K_1} + Y_1.Q_1(z^2)$$

$$Y_0 = Y_1$$

La cellule $CEL_2$ de rang pair correspond à la matrice $M(2, Q_2, \alpha_2, k_2+k_3+1)$. Une première entrée $E_{2,1}$ de la cellule $CEL_2$ coïncidant avec une première sortie $S_{3,1}$ de la cellule $CEL_3$ est reliée directement à une première sortie $S_{2,1}$ de la cellule $CEL_2$ coïncidant avec la première entrée $E_{1,1}$ de la cellule $CEL_1$.

Une seconde entrée $E_{2,2}$ de la cellule $CEL_2$ coïncidant avec une seconde sortie $S_{3,2}$ de la cellule $CEL_3$ est reliée à une ligne à retard $R_2$ de fonction de transfert égale à $z^{-2K_2}$, avec $K_2 = k_2 + k_3 + 1$. La ligne à retard $R_2$ est reliée à un multiplieur $A_2$ de gain $\alpha_2$. Le multiplieur $A_2$ est relié à une première entrée d'un additionneur $AD_2$ dont une sortie forme une seconde sortie $S_{2,2}$ de la cellule $CEL_2$.

La première entrée $E_{2,1}$ de la cellule $CEL_2$ est également reliée à un filtre $F_2$ de fonction de transfert égale à $Q_2(z^2)$ dont une sortie est reliée à une seconde entrée de l'additionneur $AD_2$.

Un premier signal d'entrée $X_2$ appliqué à la première entrée $E_{2,1}$ de la cellule $CEL_2$ est égal à un premier signal de sortie, qui est le premier signal d'entrée $X_1$ de la cellule $CEL_1$.

Un second signal d'entrée $Y_2$ appliqué à la seconde entrée $E_{2,2}$ de la cellule $CEL_2$ est retardé par la ligne à retard $R_2$, multiplié par le gain $\alpha_2$ et additionné au premier signal d'entrée filtré par le filtre $F_2$, pour former un second signal de sortie, constituant le second signal d'entrée $Y_1$ de la cellule $CEL_1$.

La seconde cellule $CEL_2$ transforme les signaux d'entrée $X_2$ et $Y_2$ en les signaux de sortie $X_1$ et $Y_1$ :

$$X_1 = X_2$$

$$Y_1 = X_2.Q_2(z^2)+Y_2.\alpha_2.z^{-2K_2} \ .$$

La structure de la cellule $CEL_2$ se déduit de celle de la cellule $CEL_1$, en renommant les première et seconde entrées et les première et seconde sorties de la cellule $CEL_1$, de rang impair, par les seconde et première entrées et seconde et première sorties de la cellule $CEL_2$ de rang pair, respectivement.

Selon la réalisation illustrée à la figure 2, la cellule $CEL_{N-1}$ est une cellule de rang pair de structure analogue à la cellule $CEL_2$. La cellule $CEL_{N-1}$ correspond à la matrice $M(N-1, Q_{N-1}, \alpha_{N-1}, k_{N-1} + k_N + 1)$ avec (N-1) pair.

La cellule $CEL_N$ correspond à la matrice $M_0(N, Q_N, \alpha_N)$ pour N impair.

Une première entrée $E_{N,1}$ de la cellule est reliée à un filtre $F_N$ de fonction de transfert égale à $Q_N(z^2)$, dont une sortie est reliée à une première entrée d'un additionneur $AD_N$. Une sortie de l'additionneur $AD_N$ forme une première sortie $S_{N,1}$ de la cellule $CEL_N$, coïncidant avec une première entrée $E_{N-1,1}$ de la cellule adjacente suivante $CEL_{N-1}$.

La première entrée $E_{N,1}$ de la cellule $CEL_N$ est en outre reliée à une seconde sortie $S_{N,2}$ de la cellule $CEL_N$, coïncidant avec une seconde entrée $E_{N-1,2}$ de la cellule adjacente suivante $CEL_{N-1}$.

La première entrée $E_{N,1}$ de la cellule $CEL_N$ est reliée par l'intermédiaire d'une ligne à retard R de fonction de transfert égale à $z^{-1}$ à une seconde entrée $E_{N,2}$ de la cellule $CEL_N$.

A partir de la seconde entrée $E_{N,2}$ la cellule $CEL_N$ comprend une ligne à retard $R_N$ de fonction de transfert égale à $z^{-2KN}$, avec $K_N = k_N$, reliée à un amplificateur $A_N$ de gain $\alpha_N$. Une sortie de l'amplificateur $A_N$ est reliée à une seconde entrée de l'additionneur $AD_N$.

Le bloc d'analyse comprend à ses première et seconde sorties $S_{1,1}$ et $S_{2,1}$ deux amplificateurs de sortie $AS_1$ et $AS_2$, respectivement. Des gains $G_1$ et $G_2$ des amplificateurs $AS_1$ et $AS_2$ sont déterminés pour imposer un gain prédéterminé au bloc d'analyse. Par exemple, pour un gain du bloc d'analyse égal à 1, les gains $G_1$ et $G_2$ des amplificateurs de sortie vérifient:

$$G_1 \cdot G_2 = \left[ \prod_{i=1}^{N} \alpha_i \right]^{-1/2}$$

Le bloc d'analyse est déterminé par le triplet $\{Q_n(z), \alpha_n, k_n\}$ de la cellule $CEL_n$, pour n variant entre 1 et N.

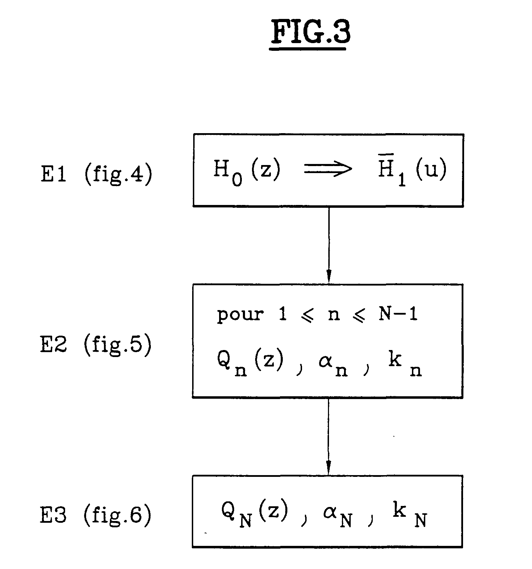

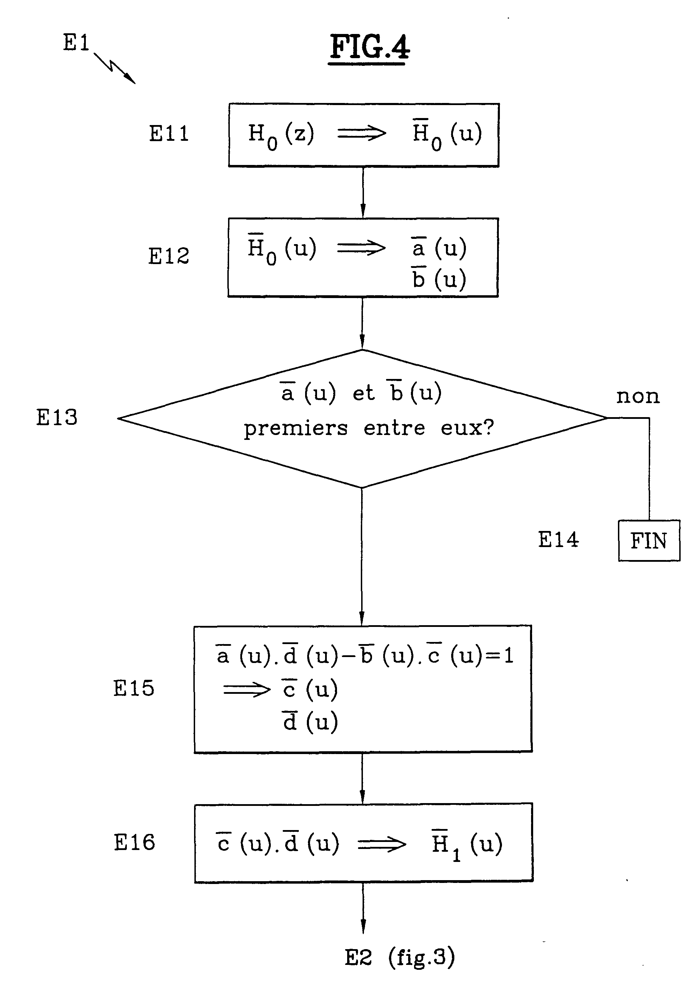

En référence à la **figure 3**, un algorithme d'identification d'un bloc d'analyse comprend trois étapes principales E1 à E3.

A partir du filtre symétrique dont la fonction de transfert $H_0(z)$ est un polynôme de longueur impaire 2p+1, un polynôme $\bar{H}_1(u)$ est construit à l'étape principale E1, où u est une variable réelle égale à $z^{1/2} + z^{-1/2}$.

A l'étape principale E2, le triplet $\{Q_n(z), \alpha_n, k_n\}$ est déterminé successivement pour n variant entre 1 et N-1, c'est-à-dire pour les cellules $CEL_1$ à $CEL_{N-1}$ (figure 2).

A l'étape principale E3, le dernier triplet $\{Q_N(z), \alpha_N, k_N\}$ correspondant à la cellule $CEL_N$ est déterminé.

En référence à la **figure 4**, l'étape principale E1 comprend six étapes E11 à E16.

A l'étape E11, le polynôme $\bar{H}_0(z)$ est déterminé, tel que :

$$z^{-p} . \bar{H}_0 (z + z^{-1}) = H_0(z) .$$

L'étape E12 est l'extraction des composantes $\bar{a}$ (u) et $\bar{b}$ (u) du polynôme $\bar{H}_0(u)$, telles que :

$$\bar{H}_0(u) = \bar{a}(u^2) + z^{-1} . \bar{b}(u^2)$$

A l'étape E13, il est vérifié si les polynômes $\bar{a}$ (u) et $\bar{b}$ (u) sont premiers entre eux. Si ce n'est pas le cas, l'algorithme passe à l'étape de fin E14. Dans ce cas, il n'existe pas de banc de filtres à reconstruction parfaite dont $H_0$ (z) soit l'un des filtres.

Si à l'étape E13 les polynômes $\bar{a}(u)$ et $\bar{b}(u)$ sont premiers entre eux, l'algorithme passe à l'étape E15 pour calculer les polynômes $\bar{c}$ (u) et $\bar{d}$ (u) qui vérifient l'équation de Bezout :

$$\bar{a} (u) . \bar{d} (u) - \bar{b} (u) . \bar{c} (u) = 1$$

A partir des polynômes $\bar{c}$ (u) et $\bar{d}$ (u), un polynôme $\bar{H}_1(u)$ est calculé à l'étape E16, en rendant unitaire la somme $\bar{c}$ (u) + $\bar{d}$ (u).

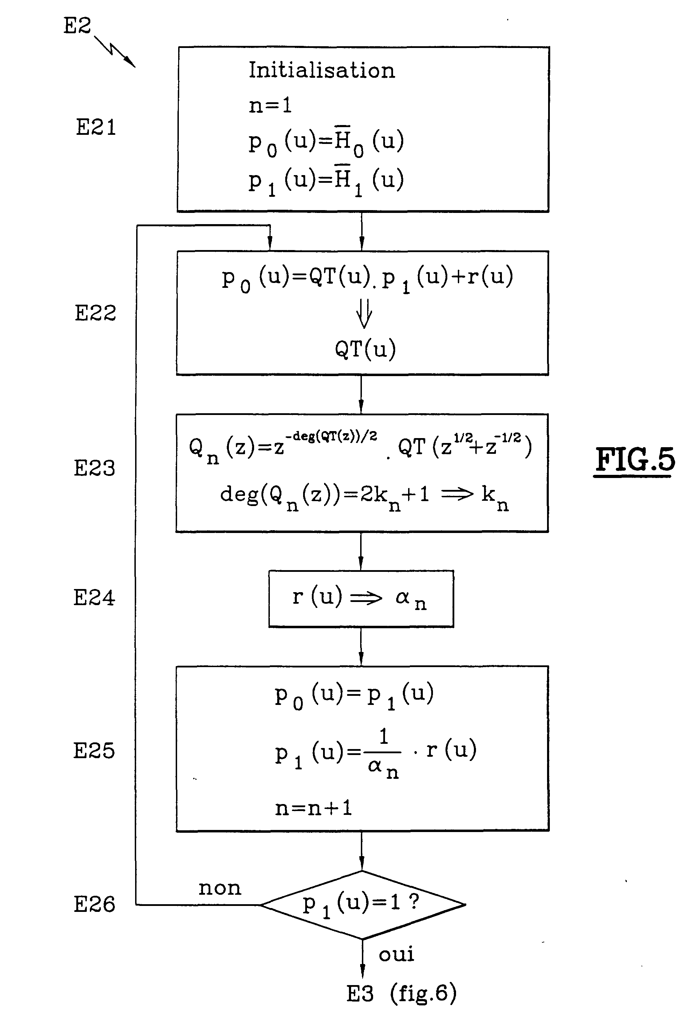

En référence à la **figure 5**, l'étape principale E2 utilise les polynômes $\bar{H}_0(u)$ et $\bar{H}_1(u)$ précédemment déterminés pour calculer les triplets $\{Q_n(z), \alpha_n, k_n\}$ pour n variant entre 1 et N-1. L'étape principale E2 comprend six étapes E21 à E26.

L'étape E21 est une initialisation de l'étape E2, à laquelle la variable n est initialisée à 1 et deux polynômes de travail $p_0(u)$ et $p_1(u)$ sont initialisés à $\bar{H}_0(u)$ et $\bar{H}_1(u)$, respectivement.

L'étape E22 est la division euclidienne du polynôme $p_0(u)$ par le polynôme $p_1(u)$. Le quotient de la division euclidienne est un polynôme unitaire de degré impair QT(u). La division euclidienne est :

$$p_0(u) = QT(u).p_1(u) + r(u).$$

Dans cette expression, le polynôme r(u) est le reste de la division euclidienne.

A l'étape E23, le polynôme $Q_n(z)$ est déterminé par la relation

$$Q_n(z) = z^{-deg(QT(z))/2} . QT(z^{1/2} + z^{-1/2}) ,$$

où deg (QT(z)) dénote le degré du polynône QT(z).

Le degré $deg(Q_n(z))$ du polynôme $Q_n(z)$ est impair et détermine le coefficient $k_n$ par la relation

$$deg(Q_n(z)) = 2k_n+1$$

d'où

$$k_n = (deg(Q_n(z)) - 1)/2$$

A l'étape E24, le gain $\alpha_n$ est égal au coefficient du terme de plus haut degré du polynôme r(u).

A l'étape E25, le polynôme $p_1(u)$ est transformé en un autre polynôme de travail $p_0(u)$. Le polynôme r(u) est divisé par le gain $\alpha_n$ pour être transformé en un autre polynôme de travail $p_1(u)$. L'indice n est incrémenté de 1.

Le polynôme de travail $p_1(u)$ est comparé à l'entier 1 à l'étape E26. Si le polynôme $p_1(u)$ est différent de 1, les étapes E22 à E25 sont accomplies à nouveau pour les polynômes $p_0(u)$ et $p_1(u)$ et pour l'indice n dernièrement déterminés à l'étape E25.

Lorsque le polynôme $p_1(u)$ est égal à l'entier 1, l'étape E2 est terminée. L'indice N est déterminé et égal au dernier indice n calculé à l'étape E25 et les triplets ($Q_n(z)$, $\alpha_n$, $k_n$} sont déterminés pour n variant entre 1 et N-1. L'algorithme passe à l'étape E3.

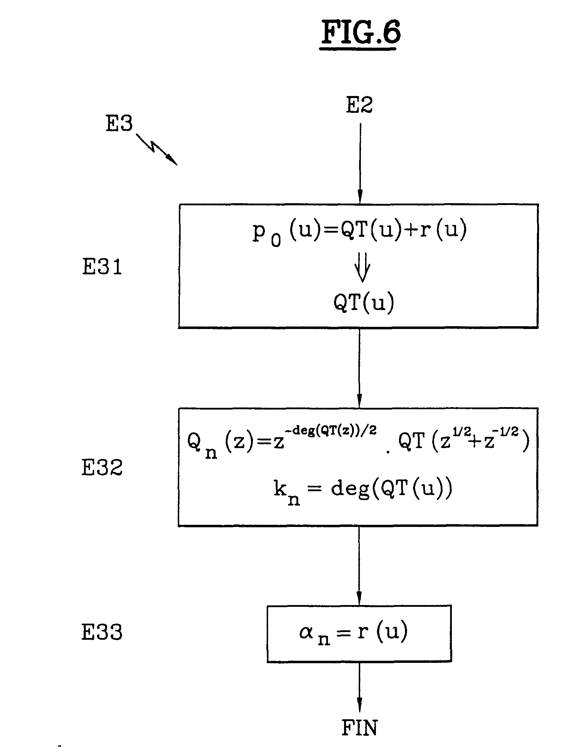

En référence à la **figure 6,** l'étape principale E3 comprend trois étapes E31 à E33.

L'étape E31 utilise les derniers polynômes $p_0(u)$ et $p_1(u)$ et le dernier indice n = N déterminés à l'étape E25.

L'étape E31 est analogue à l'étape E22 précédemment décrite. Le polynôme $p_0(u)$ est divisé par le polynôme $p_1(u) = 1$ pour déterminer le quotient QT(u) et le reste r(u) de la division euclidienne correspondante.

A l'étape E32, analogue à l'étape E23 précédemment décrite, le polynôme $Q_N(z)$ est déterminé par la relation :

$$Q_N(z) = z^{-deg(QT(z))/2} . QT (z^{1/2} + z^{-1/2})$$

et le coefficient $k_N$ est égal au degré deg(QT(z)) du polynôme QT(z).

L'étape E33 détermine le gain $\alpha_N$, qui est égal au reste r(u) de la division euclidienne de l'étape E31.

A l'issue de l'étape E33, le dernier triplet {$Q_N(z)$, $\alpha_N$, $k_N$} du bloc d'analyse est déterminé.

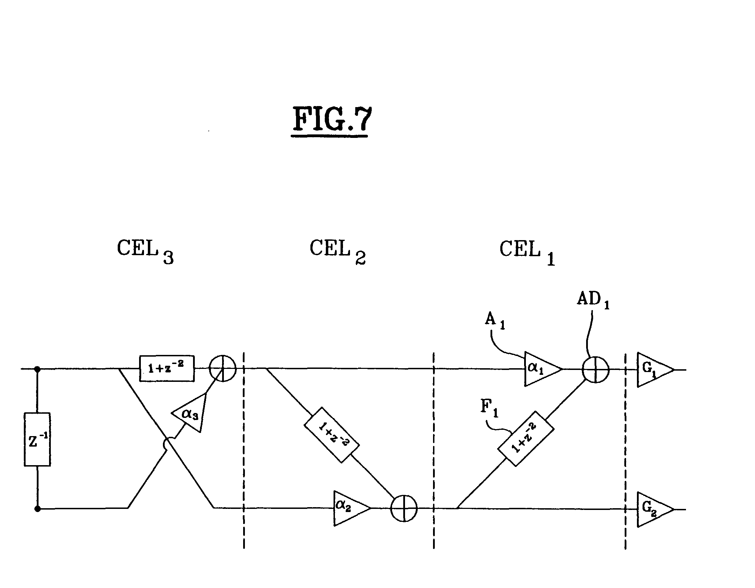

En référence à la **figure 7**, un exemple de réalisation d'un bloc de filtre d'analyse a pour fonction de transfert :

$$H_0(z) = (1 + z^{-1})^6 ,$$

soit

$$H_0(z) = 1 + 6.z^{-1} + 15.z^{-2} + 20.z^{-3} + 15.z^{-4} + 6.z^{-5} + z^{-6}$$

L'algorithme d'identification précédemment décrit détermine les triplets {$Q_1(z)$, $\alpha_1$, $k_1$} à {$Q_N(z)$, $\alpha_N$, $k_N$} définissant les cellules $CEL_1$ à $CEL_N$.

Le résultat est :

$$Q_1(z) = 1 + z^{-2} \; ; \; \alpha_1 = 4/3 \; ; \; k_1 = 0 \; ;$$

$$Q_2(z) = 1 + z^{-2} \; ; \; \alpha_2 = 32/3 \; ; \; k_2 = 0 \; ;$$

$$Q_3(z) = 1 + z^{-2} \; ; \; \alpha_3 = 6 \; ; \; k_3 = 0 \; .$$

Le banc d'analyse comprend trois cellules $CEL_1$, $CEL_2$ et $CEL_3$. Les cellules $CEL_1$ à $CEL_3$ comprennent les éléments décrits en référence à la figure 2. Ainsi, la cellule $CEL_1$ comprend le filtre $F_1$ de fonction de transfert $Q_1(z^2)$ = $1 + z^{-2}$, le multiplieur $A_1$ de gain $\alpha_1$ et l'additionneur $AD_1$. Le retard imposé dans la cellule $CEL_1$ est nul, et la cellule $CEL_1$ ne comprend pas de ligne à retard.

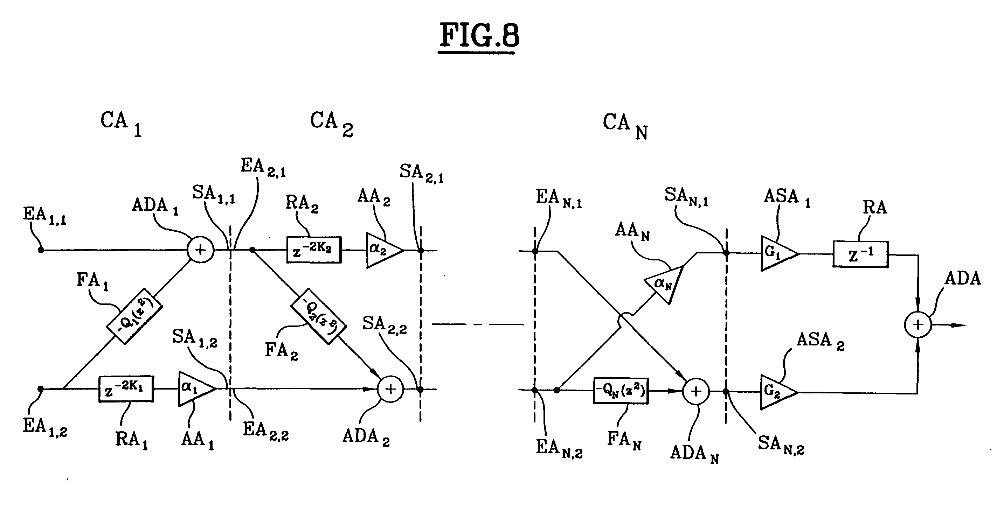

En référence à la **figure 8**, le bloc de synthèse 2 correspondant au bloc d'analyse 1 selon la figure 2 se déduit directement du bloc d'analyse 1.

Le bloc de synthèse 2 comprend N quadripôles ou cellules à deux entrées et deux sorties successives $CA_1$ à $CA_N$, réalisant des opérations respectivement duales de celles des cellules $CEL_1$ à $CEL_N$.

Les cellules $CA_1$ à $CA_{N-1}$ ont alternativement une structure de rang impair et une structure de rang pair qui diffèrent quelque peu.

La cellule $CA_1$ comprend une première entrée $EA_{1,1}$ reliée à une première entrée d'un additionneur $ADA_1$ dont une sortie est une première sortie $SA_{1,1}$ de la cellule $CA_1$.

La cellule $CA_1$ comprend une seconde entrée $EA_{1,2}$ reliée à une seconde entrée de l'additionneur $ADA_1$ à travers un filtre $FA_1$. La fonction de transfert du filtre $FA_1$ est $-Q_1(z^2)$.

La seconde entrée $EA_{1,2}$ de la cellule $CA_1$ est également reliée à une ligne à retard $RA_1$ imposant un retard égal à $2K_1$, en série avec un amplificateur ou multiplieur $AA_1$ de gain $\alpha_1$. Une sortie du multiplieur $AA_1$ est une seconde sortie $SA_{2,2}$ de la cellule $CA_1$.

Les première et seconde sorties $SA_{1,1}$ et $SA_{1,2}$ de la cellule $CA_1$ sont reliées respectivement à des première et seconde entrées $EA_{2,1}$ et $EA_{2,2}$ de la cellule $CA_2$.

A partir de la première entrée $EA_{2,1}$, la cellule $CA_2$ comprend une ligne à retard $RA_2$ imposant un retard égal à $2K_2$ en série avec un multiplieur $AA_2$ de gain $\alpha_2$. Une sortie du multiplieur $AA_2$ est une première sortie $SA_{2,1}$ de la cellule $CA_2$.

La seconde entrée $EA_{2,2}$ de la cellule $CA_2$ est reliée à une première entrée d'un additionneur $ADA_2$ dont une sortie est une seconde sortie $SA_{2,2}$ de la cellule $CA_2$.

La première entrée $EA_{2,1}$ de la cellule $CA_2$ est également reliée à un filtre $FA_2$ de fonction de transfert égale à $-Q_2(z^2)$ et dont une sortie est reliée à une seconde entrée de l'additionneur $ADA_2$.

La dernière cellule $CA_N$ comprend une première entrée $EA_{N,1}$ reliée à une première entrée d'un additionneur $ADA_N$.

Une seconde entrée $EA_{N,2}$ de la cellule $CA_N$ est reliée à une entrée d'un multiplieur $AA_N$ de gain $\alpha_N$. Une sortie de l'amplificateur $AA_N$ est une première sortie $SA_{N,1}$ de la cellule $CA_N$. La seconde entrée de la cellule $CA_N$ est également reliée à un filtre $FA_N$ de fonction de transfert égale à $-Q_N(z^2)$. Une sortie du filtre $FA_N$ est reliée à une seconde entrée de l'additionneur $ADA_N$. Une sortie de l'additionneur $ADA_N$ est une seconde sortie $SA_{N,2}$ de la cellule $CA_N$.

La première sortie $SA_{N,1}$ de la cellule $CA_N$ est reliée à un multiplieur $ASA_1$ de gain $G_1$ en série avec une ligne à retard RA imposant un retard de 1. La ligne à retard RA est reliée à une première entrée d'un additionneur ADA dont une sortie est la sortie du bloc de synthèse 2.

La seconde sortie de la cellule $CA_N$ est reliée à un multiplieur $ASA_2$ de gain $G_2$ dont une sortie est reliée à une seconde entrée de l'additionneur ADA.

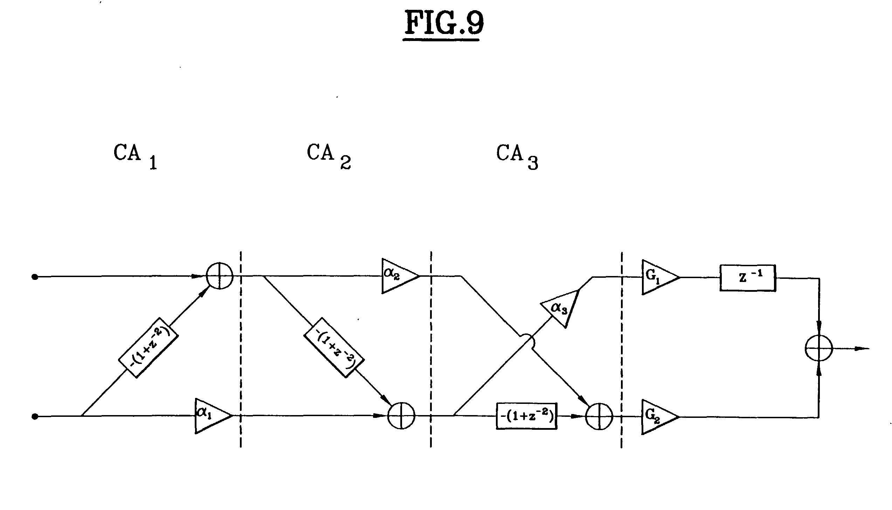

En référence à la **figure 9**, le bloc de synthèse correspondant au bloc d'analyse de la figure 7 comprend trois cellules $CA_1$, $CA_2$ et $CA_3$.

Les blocs d'analyse et de synthèse selon l'invention sont utilisés dans un système de codage-décodage pour transmission de signaux numériques.

Un codeur de source, par exemple pour des signaux sonores, réalise classiquement trois opérations principales qui sont une transformation, une quantification et un codage du signal numérique à transmettre. Un décodeur réalise trois opérations duales des précédentes qui sont un décodage, une quantification inverse et une transformation inverse du signal numérique reçu.

Les blocs d'analyse et de synthèse selon l'invention simplifient la mise en oeuvre des opérations de transformation. La complexité opératoire exprimée en nombre d'opérations par unité de temps est moindre que dans les dispositifs de la technique antérieure.

**Revendications**

1. Dispositif pour analyser un signal numérique en deux sous-bandes de fréquence, caractérisé en ce qu'il comprend au moins une cellule ($CEL_1$, $CEL_2$) comprenant :

   - depuis une première entrée ($E_{1,1}$, $E_{2,2}$) de la cellule, une ligne à retard ($R_1$, $R_2$) reliée à un multiplieur ($A_1$, $A_2$) relié à une première entrée d'un additionneur ($AD_1$, $AD_2$) ayant une sortie formant une première sortie ($S_{1,1}$, $S_{2,2}$) de la cellule,
   - une liaison directe entre une seconde entrée ($E_{1,2}$, $E_{2,1}$) et une seconde sortie ($S_{1,2}$, $S_{2,1}$) de la cellule, et
   - un filtre ($F_1$, $F_2$) entre la seconde entrée ($E_{1,2}$, $E_{2,1}$) de la cellule et une seconde entrée de l'additionneur ($AD_1$, $AD_2$).

2. Dispositif conforme à la revendication 1, caractérisé en ce qu'il comprend une suite de plusieurs cellules successives ($CEL_1$, $CEL_2$), et en ce que la sortie de l'additionneur ($AD_1$, $AD_2$) de l'une ($CEL_2$) de deux cellules successives est reliée à la liaison directe de l'autre ($CEL_1$) desdites deux cellules successives, et en ce que la liaison directe de ladite l'une ($CEL_2$) des deux cellules successives a une sortie reliée à une entrée de la ligne à retard de ladite autre ($CEL_1$) des deux cellules successives.

3. Dispositif conforme à la revendication 1 ou 2, caractérisé en ce qu'il comprend en outre une cellule d'extrémité ($CEL_N$) comprenant :

   - entre une première entrée ($E_{N,1}$) et une première sortie ($S_{N,1}$), un filtre ($F_N$) relié à une première entrée d'un additionneur ($AD_N$) ayant une sortie formant la première sortie de la cellule d'extrémité,
   - une liaison directe entre ladite première entrée ($E_{N,1}$) et une seconde sortie ($S_{N,2}$) de la cellule d'extrémité, et
   - une ligne à retard ($R_N$) et un multiplieur ($A_N$) reliés en série entre une seconde entrée ($E_{N,2}$) de la cellule d'extrémité ($CEL_N$) et une seconde entrée de l'additionneur ($AD_N$).

4. Dispositif conforme aux revendications 2 et 3, caractérisé en ce que la sortie de l'additionneur ($AD_N$) de la cellule d'extrémité ($CEL_N$) est reliée à la liaison directe d'une première cellule ($CEL_{N-1}$) dans ladite suite de cellules, et en ce que la seconde sortie ($S_{N,2}$) de ladite cellule d'extrémité ($CEL_N$) est reliée à la ligne à retard ($R_{N-1}$) de ladite première cellule dans ladite suite.

5. Dispositif pour synthétiser un signal numérique, caractérisé en ce qu'il comprend au moins une cellule ($CA_1$, $CA_2$) comprenant :

   - une combinaison série d'une ligne à retard ($RA_1$, $RA_2$) et d'un multiplieur ($AA_1$, $AA_2$) entre une première entrée ($EA_{1,2}$, $EA_{2,1}$) et une première sortie ($SA_{1,2}$, $SA_{2,1}$) de la cellule,
   - depuis ladite première entrée ($EA_{1,2}$, $EA_{2,1}$), un filtre ($FA_1$, $FA_2$) relié à une première entrée d'un additionneur ($ADA_1$, $ADA_2$) ayant une sortie formant une seconde sortie ($SA_{1,1}$, $SA_{2,2}$) de la cellule, et
   - une liaison directe entre une seconde entrée ($EA_{1,1}$, $EA_{2,2}$) de la cellule et une seconde entrée du additionneur ($ADA_1$, $ADA_2$).

6. Dispositif conforme à la revendication 5, caractérisé en ce qu'il comprend une suite de plusieurs cellules successives ($CA_1$, $CA_2$), et en ce que la sortie de l'additionneur ($ADA_1$, $ADA_2$) de l'une ($CA_1$) de deux cellules successives est reliée à la combinaison série de l'autre ($CA_2$) desdites deux cellules successives, et en ce que la combinaison série de ladite une ($CA_1$) des deux cellules successives a une sortie reliée à la seconde entrée de l'additionneur de ladite autre (CA2) des deux troisièmes cellules sucessives.

7. Dispositif conforme à la revendication 5 ou 6, caractérisé en ce qu'il comprend en outre une cellule d'extrémité ($CA_N$) comprenant :

   - entre une première entrée ($EA_{N,2}$) et une première sortie ($SA_{N,2}$), un filtre ($FA_N$) relié à une première entrée d'un additionneur ($ADA_N$) ayant une sortie formant ladite première sortie de la cellule d'extrémité,

   - une liaison directe entre une seconde entrée ($EA_{N,1}$) de la cellule d'extrémité et une seconde entrée de l'additionneur ($ADA_N$), et

   - un multiplieur ($AA_N$) entre la première entrée ($EA_{N,2}$) de la cellule d'extrémité ($CA_N$) et une seconde sortie (SA$_{N,1}$)de la cellule d'extrémité (CA$_N$).

**8.** Dispositif conforme aux revendications 6 et 7, caractérisé en ce que l'entrée du filtre (FA$_N$) de la cellule d'extrémité (CA$_N$) est reliée à la sortie de l'additionneur d'une dernière cellule (CA$_{N-1}$) dans ladite suite de cellules, et en ce que la seconde entrée (EA$_{N,2}$) de l'additionneur (ADA$_N$) de la cellule d'extrémité est reliée à la sortie de la combinaison série de ladite dernière cellule dans ladite suite.

**Patentansprüche**

**1.** Vorrichtung zur Analyse eines Digitalsignals in zwei Frequenzteilbänder, dadurch gekennzeichnet, dass sie mindestens eine Zelle (CEL$_1$, CEL$_2$) umfasst, bestehend aus:

- ausgehend von einem ersten Eingang (E$_{1,1}$ , E$_{2,2}$) der Zelle einer Verzögerungsleitung (R$_1$, R$_2$), die mit einem Multiplizierglied (A$_1$, A$_2$) verbunden ist, das mit einem ersten Eingang eines Addierers (AD$_1$, AD$_2$) verbunden ist, der über einen Ausgang verfügt, der einen ersten Ausgang (S$_{1,1}$ , S$_{2,2}$) der Zelle bildet,
- einer direkten Verbindung zwischen einem zweiten Eingang (E$_{1,2}$ , E$_{2,1}$) und einem zweiten Ausgang (S$_{1,2}$ , S$_{2,1}$) der Zelle, und
- einem Filter (F$_1$, F$_2$) zwischen dem zweiten Eingang (E$_{1,2}$ , E$_{2,1}$) der Zelle und einem zweiten Eingang des Addierers (AD$_1$, AD$_2$).

**2.** Vorrichtung nach Patentanspruch 1, dadurch gekennzeichnet, dass sie eine Reihe mehrerer aufeinanderfolgender Zellen (CEL$_1$, CEL$_2$) umfasst und dadurch, dass der Ausgang des Addierers (AD$_1$, AD$_2$) der einen (CEL$_2$) von zwei aufeinanderfolgenden Zellen mit der direkten Verbindung der anderen (CEL$_1$) der genannten beiden aufeinanderfolgenden Zellen verbunden ist und darin, dass ein Ausgang der direkten Verbindung der genannten einen (CEL$_2$) der beiden aufeinanderfolgenden Zellen mit einem Eingang der Verzögerungsleitung der genannten anderen (CEL$_1$) der beiden aufeinanderfolgenden Zellen verbunden ist.

**3.** Vorrichtung nach Patentanspruch 1 oder 2, dadurch gekennzeichnet, dass sie außerdem eine Endzelle (CEL$_N$) umfasst, bestehend aus

- zwischen einem ersten Eingang (E$_{N,1}$) und einem ersten Ausgang (S$_{N,1}$): einem Filter (F$_N$), der mit einem ersten Eingang eines Addierers (AD$_N$) verbunden ist, der über einen Ausgang verfügt, der den ersten Ausgang der Endzelle bildet,
- einer direkten Verbindung zwischen dem genannten ersten Eingang (E$_{N,1}$) und einem zweiten Ausgang (S$_{N,2}$) der Endzelle, und
- einer Verzögerungsleitung (R$_N$) und einem Multiplizierglied (A$_N$), die zwischen einem zweiten Eingang (E$_{N,2}$) der Endzelle (CEL$_N$) und einem zweiten Eingang des Addierers (AD$_N$) in Reihe geschaltet sind.

**4.** Vorrichtung nach den Patentansprüchen 2 und 3, dadurch gekennzeichnet, dass der Ausgang des Addierers (AD$_N$) der Endzelle (CEL$_N$) mit der direkten Verbindung einer ersten Zelle (CEL$_{N-1}$) in der genannten Reihe von Zellen verbunden ist und dadurch, dass der zweite Ausgang (S$_{N,2}$) der genannten Endzelle (CEL$_N$) mit der Verzögerungsleitung (R$_{N-1}$) der genannten ersten Zelle in der genannten Reihe verbunden ist.

**5.** Vorrichtung zur Synthese eines Digitalsignals, dadurch gekennzeichnet, dass sie mindestens eine Zelle (CA$_1$, CA$_2$) umfasst, bestehend aus:

- einer Reihenschaltung einer Verzögerungsleitung (RA$_1$, RA$_2$) und eines Multipliziergliedes (AA$_1$, AA$_2$) zwischen einem ersten Eingang (EA$_{1,2}$, EA$_{2,1}$) und einem ersten Ausgang (SA$_{1,2}$ , SA$_{2,1}$) der Zelle,
- ausgehend vom genannten ersten Eingang (EA$_{1,2}$, EA$_{2,1}$) einem Filter (FA$_1$, FA$_2$), der mit einem ersten Eingang eines Addierers (ADA$_1$, ADA$_2$) verbunden ist, der über einen ersten Ausgang verfügt, der einen zweiten Ausgang (SA$_{1,1}$ , SA$_{2,2}$) der Zelle bildet, und
- einer direkten Verbindung zwischen einem zweiten Eingang (EA$_{1,1}$ , EA$_{2,2}$) der Zelle und einem zweiten Eingang des Addierers (ADA$_1$, ADA$_2$).

**6.** Vorrichtung nach Patentanspruch 5, dadurch gekennzeichnet, dass sie eine Reihe mehrerer aufeinanderfolgenden Zellen (CA$_1$, CA$_2$) umfasst und dadurch, dass der Ausgang des Addierers (ADA$_1$, ADA$_2$) der einen (CA$_1$) zweier aufeinanderfolgender Zellen mit der Reihenschaltung der anderen (CA$_2$) der beiden genannten aufeinanderfol-

genden Zellen verbunden ist und darin, dass ein Ausgang der Reihenschaltung der genannten einen (CA$_1$) der beiden aufeinanderfolgenden Zellen mit dem zweiten Eingang des Addierers der genannten anderen (CA$_2$) der beiden aufeinanderfolgenden Zellen verbunden ist.

**7.** Vorrichtung nach Patentanspruch 5 oder 6, dadurch gekennzeichnet, dass sie außerdem eine Endzelle (CA$_N$) umfasst, bestehend aus

- zwischen einem ersten Eingang (EA$_{N,2}$) und einem ersten Ausgang (SA$_{N,2}$): einem Filter (FA$_N$), der mit einem ersten Eingang eines Addierers (ADA$_N$) verbunden ist, der über einen Ausgang verfügt, der den genannten ersten Ausgang der Endzelle darstellt,
- einer direkten Verbindung zwischen einem zweiten Eingang (EA$_{N,1}$) der Endzelle und einem zweiten Eingang des Addierers (ADA$_N$), und
- einem Multiplizierglied (AA$_N$) zwischen dem ersten Eingang (EA$_{N,2}$) der Endzelle (CA$_N$) und einem zweiten Ausgang (SA$_{N,1}$) der Endzelle (CA$_N$).

**8.** Vorrichtung nach den Patentansprüchen 6 und 7, dadurch gekennzeichnet, dass der Eingang des Filters (FA$_N$) der Endzelle (CA$_N$) mit dem Ausgang des Addierers einer letzten Zelle (CA$_{N-1}$) in der genannten Reihe von Zellen verbunden ist und darin, dass der zweite Eingang (EA$_{N,2}$) des Addierers (ADA$_N$) der Endzelle mit dem Ausgang der Reihenschaltung der genannten letzten Zelle der genannten Reihe verbunden ist.

**Claims**

**1.** A device for analysing a digital signal in two frequency sub-bands, characterised in that it comprises at least one cell (CEL$_1$, CEL$_2$) comprising:

- from a first input (E$_{1,1}$, E$_{2,2}$) of the cell, a delay line (R$_1$, R$_2$) connected to a multiplier (A$_1$, A$_2$) connected to a first input of an adder (AD$_1$, AD$_2$) having an output forming a first output (S$_{1,1}$, S$_{2,2}$) of the cell,

- a direct connection between a second input (E$_{1,2}$, E$_{2,1}$) and a second output (S$_{1,1}$, S$_{2,1}$) of the cell, and

- a filter (F$_1$, F$_2$) between the second input (E$_{1,2}$, E$_{2,1}$) of the cell and a second input of the adder (AD$_1$, AD$_2$) .

**2.** A device according to claim 1, characterised in that it comprises a sequence of a number of successive cells (CEL$_1$, CEL$_2$) and in that the output of the adder (AD$_1$, AD$_2$) of one (CEL$_2$) out of two successive cells is connected to the direct connection between the other (CEL$_1$) of the said two successive cells and in that the direct connection of the said one (CEL$_2$) of the two successive cells has an output connected to an input of the delay line of the other (CEL$_1$) of the two successive cells.

**3.** A device according to claim 1 or 2, characterised in that it also comprises an end cell (CEL$_N$) comprising:

- a filter (F$_N$) between a first input (E$_{N,1}$) and a first output (S$_{N,1}$), the filter being connected to a first input of an adder (AD$_N$) having an output forming the first output of the second end cell,

- a direct connection between the said first input (E$_{N,1}$) and a second output (S$_{N,2}$) of the end cell, and

- a delay line (R$_N$) and a multiplier (A$_N$) connected in series between a second input (E$_{N,2}$) of the end cell (CEL$_N$) and a second input of the adder (AD$_N$) .

**4.** A device according to claims 2 and 3, characterised in that the output of the adder (AD$_N$) of the end cell (CEL$_N$) is connected to the direct connection of a first cell (CEL$_{N-1}$) in the said sequence of cells, and in that the second output (S$_{N,2}$) of the said end cell (CEL$_N$) is connected to the delay line (R$_{N-1}$) of the first cell in the said series.

**5.** A device for synthesising a digital signal, characterised in that it comprises at least one cell (CA$_1$, CA$_2$) comprising:

- a series combination of a delay line (RA$_1$, RA$_2$) and a multiplier (AA$_1$, AA$_2$) between a first input (EA$_{1,2}$, EA$_{2,1}$) and a first output (SA$_{1,2}$, SA$_{2,1}$) of the cell,

- from the first input ($EA_{1,2}$, $EA_{2,1}$), a filter ($FA_1$, $FA_2$) connected to a first input of an adder ($ADA_1$, $ADA_2$) having an output forming a second output ($SA_{1,1}$, $SA_{2,2}$) of the cell and

- a direct connection between a second input ($EA_{1,1}$, $EA_{2,2}$) of the cell and a second input of the adder ($ADA_1$, $ADA_2$).

6. A device according to claim 5, characterised in that it comprises a sequence of a number of successive cells ($CA_1$, $CA_2$), and in that the output of the adder ($ADA_1$, $ADA_2$) of one ($CA_1$) of two successive cells is connected to the series combination of the other ($CA_2$) of the said two successive cells, and in that the series combination of the said one ($CA_1$) of the two successive cells has an output connected to the second input of the adder of the said other ($CA_2$) of the two third successive cells.

7. A device according to claim 5 or 6, characterised in that it also comprises an end cell ($CA_N$) comprising:

- a filter ($FA_N$) between a first input ($EA_{N,2}$) and a first output ($SA_{N,2}$), the filter being connected to a first input of an adder ($ADA_N$) having an output forming the said first output of the end cell,

- a direct connection between a second input ($EA_{N,1}$) of the end cell and a second input of the adder ($ADA_N$), and

- a multiplier ($AA_N$) between the first input ($EA_{N,2}$) of the end cell ($CA_N$) and a second output ($SA_{N,1}$) of the end cell ($CA_N$).

8. A device according to claims 6 and 7, characterised in that the input of the filter ($FA_N$) of the end cell ($CA_N$) is connected to the output of the adder of a last cell ($CA_{N-1}$) in the said sequence of cells, and in that the second input ($EA_{N,2}$) of the adder ($ADA_N$) of the end cell is connected to the output of the series combination of the said last cell in the said sequence.

# FIG.1

1 (Fig.2)　　　　　　　　　　2 (Fig.8)

$X(Z)$

$H_0(Z)$ — 10

$H_1(Z)$ — 11

12 — $\downarrow 2$

13 — $\downarrow 2$

20 — $\uparrow 2$

21 — $\uparrow 2$

22 — $G_0(Z)$

23 — $G_1(Z)$

$+$ — 24

$Y(Z)$

EP 0 763 892 B1

## FIG.2

# FIG.3

E1 (fig.4)    $H_0(z) \implies \overline{H}_1(u)$

E2 (fig.5)    pour $1 \leqslant n \leqslant N-1$   $Q_n(z), \alpha_n, k_n$

E3 (fig.6)    $Q_N(z), \alpha_N, k_N$

# FIG.4

E1

E11 $\quad\boxed{H_0\,(z) \implies \bar{H}_0\,(u)}$

E12 $\quad\boxed{\bar{H}_0\,(u) \implies \begin{array}{l}\bar{a}\,(u)\\ \bar{b}\,(u)\end{array}}$

E13 $\quad\left\langle\begin{array}{c}\bar{a}\,(u)\ \text{et}\ \bar{b}\,(u)\\ \text{premiers entre eux?}\end{array}\right\rangle$ non

E14 $\quad\boxed{\text{FIN}}$

E15 $\quad\boxed{\begin{array}{l}\bar{a}\,(u).\bar{d}\,(u)-\bar{b}\,(u).\bar{c}\,(u)=1\\ \implies \bar{c}\,(u)\\ \qquad\ \bar{d}\,(u)\end{array}}$

E16 $\quad\boxed{\bar{c}\,(u).\bar{d}\,(u) \implies \bar{H}_1\,(u)}$

E2 (fig.3)

E2

E21 — Initialisation
$n=1$
$p_0(u)=\overline{H}_0(u)$
$p_1(u)=\overline{H}_1(u)$

E22 — $p_0(u)=QT(u).p_1(u)+r(u)$
$\Downarrow$
$QT(u)$

E23 — $Q_n(z)=z^{-\deg(QT(z))/2} . QT(z^{1/2}+z^{-1/2})$
$\deg(Q_n(z))=2k_n+1 \Longrightarrow k_n$

**FIG.5**

E24 — $r(u) \Longrightarrow \alpha_n$

E25 — $p_0(u)=p_1(u)$
$p_1(u)=\dfrac{1}{\alpha_n} . r(u)$
$n=n+1$

E26 — non — $p_1(u)=1$ ?
oui

E3 (fig.6)

# FIG.6

E2

E3

E31

$$p_0(u) = QT(u) + r(u)$$

$$\Downarrow$$

$$QT(u)$$

E32

$$Q_n(z) = z^{-\deg(QT(z))/2} \cdot QT(z^{1/2} + z^{-1/2})$$

$$k_n = \deg(QT(u))$$

E33

$$\alpha_n = r(u)$$

FIN

# FIG.7

EP 0 763 892 B1

EP 0 763 892 B1

## FIG.8

# FIG.9

EP 0 763 892 B1

$CA_1$          $CA_2$          $CA_3$